# EUROPEAN PATENT APPLICATION

(11) **EP 4 436 320 A1**
(43) Date of publication of application: **25.09.2024**
(21) Application number: 24165490.4
(22) Date of filing: 22.03.2024
(51) Int. Cl.: H05K 1/02, H01L 23/538, H05K 1/18, H05K 3/46

(54) **COMPONENTS-EMBEDDED CIRCUIT BOARD**

(30) Priority: 23.03.2023 JP 2023046307
(71) Applicant: Nabtesco Corporation, Tokyo 102-0093 (JP); National University Corporation Tokai National Higher Education and Research System, Nagoya-shi Aichi 4648601 (JP)
(72) Inventor: Koizumi, Katsuhiro, Tokyo, 102-0093 (JP); Inada, Taro, Tokyo, 102-0093 (JP); Yamamoto, Masayoshi, Nagoya-shi, Aichi, 464-8601 (JP); Nagai, Tomotaka, Nagoya-shi, Aichi, 464-8601 (JP)
(74) Representative: Grünecker Patent- und Rechtsanwälte PartG mbB

(57) **Abstract**

A component-embedded circuit board (1) includes: a first conductive layer (11) in which a high potential side power supply terminal (100H) is provided; a second conductive layer (12) in which a low potential side power supply terminal (100L) is provided; an insulating layer (20) formed between the first conductive layer (11) and the second conductive layer (12); a first semiconductor element (41) and a second semiconductor element (42) that are embedded in the insulating layer (20) and that each include a high potential side connection terminal (42H) and a low potential side connection terminal (42L) exposed from the insulating layer (20); and an intermediate conductor (30) that connects the low potential side connection terminal (41L) of the first semiconductor element (41) and the high potential side connection terminal (42H) of the second semiconductor element (42). The first semiconductor element (41) and the second semiconductor element (42), which are arranged apart in an in-plane direction of the insulating layer (20), and the intermediate conductor (30) are provided between the first conductive layer (11) and the second conductive layer (12). The high potential side power supply terminal (100H) and the high potential side connection terminal (41H) of the first semiconductor element (41) exposed from the insulating layer (20) are connected by the first conductive layer (11). The low potential side power supply terminal (100L) and the low potential side connection terminal (42L) of the second semiconductor element (42) exposed from the insulating layer (20) are connected by the second conductive layer (12). At least one of the first conductive layer (11) or the second conductive layer (12) is configured to have a portion that overlaps the intermediate conductor (30) when viewed from a laminating direction of the first conductive layer (11) and the second conductive layer (12).

## Description

### BACKGROUND OF THE INVENTION

### 1. Field of the Invention

The present disclosure relates to a component-embedded circuit board.

### 2. Description of the Related Art

For conventional electronic devices, a technology of mounting electronic components on the surface of a printed circuit board has been generally used. Meanwhile, it is considered that, by adopting a component-embedded circuit board in which electronic components are mounted inside a printed circuit board, the density of the electronic circuit can be further increased.

Patent Literature 1: Japanese Unexamined Patent Application Publication No. 2013-222924

In an electronic device employing a component-embedded circuit board, when a current flows through the input wiring (e.g., a copper foil pattern from a P potential electrode and an N potential electrode to a switching FET), a magnetic flux is generated in the direction of circling the copper foil pattern (the right-handed screw rule). When a magnetic flux is generated around a conductor, the conductor has an inductance component. In a switching FET, current intermittence generally occurs at the transition of ON/OFF operation (the switching timing). When there is an inductance in the wiring, a voltage is generated by the current intermittence and inductance, which may cause noise. In the field of power electronics, in particular, since the switching operation is essential, noise reduction is strongly desired.

Patent Literature 1 discloses a technology for improving the shielding property of a component-embedded circuit board to improve reliability against noise. This technology, however, cannot cope with noise caused by operation of an electronic component that requires switching operation.

### SUMMARY OF THE INVENTION

The present disclosure has been made in view of such an issue, and a purpose thereof is to reduce noise in a component-embedded circuit board in which an electronic component that requires switching operation is mounted.

In response to the above issue, a component-embedded circuit board according to one embodiment of the present disclosure includes: a first conductive layer in which a high potential side power supply terminal is provided; a second conductive layer in which a low potential side power supply terminal is provided; an insulating layer formed between the first conductive layer and the second conductive layer; a first semiconductor element and a second semiconductor element that are embedded in the insulating layer and that each include a high potential side connection terminal and a low potential side connection terminal exposed from the insulating layer; and an intermediate conductor that connects the low potential side connection terminal of the first semiconductor element and the high potential side connection terminal of the second semiconductor element. The first semiconductor element and the second semiconductor element, which are arranged apart in an in-plane direction of the insulating layer, and the intermediate conductor are provided between the first conductive layer and the second conductive layer. The high potential side power supply terminal and the high potential side connection terminal of the first semiconductor element exposed from the insulating layer are connected by the first conductive layer. The low potential side power supply terminal and the low potential side connection terminal of the second semiconductor element exposed from the insulating layer are connected by the second conductive layer. At least one of the first conductive layer or the second conductive layer is configured to have a portion that overlaps the intermediate conductor when viewed from a laminating direction of the first conductive layer and the second conductive layer.

According to this embodiment, at least part of the current flowing on the plane of at least one of the first conductive layer or the second conductive layer overlaps with and becomes opposite in direction to part of the current flowing through the intermediate conductor. Between the conductors through which such overlapping currents flow in opposite directions, the magnetic fluxes generated in the respective conductors cancel each other out. With such cancellation of magnetic fluxes, the inductance generated in each conductor is reduced, so that switching noise can be reduced.

In another embodiment of the present disclosure, the first semiconductor element and the second semiconductor element may be embedded in the insulating layer between the first conductive layer and the second conductive layer. The intermediate conductor may include: a conductive component that is embedded in the insulating layer and that includes a high potential side connection terminal and a low potential side connection terminal exposed from the insulating layer; a third conductive layer that connects the low potential side connection terminal of the first semiconductor element and the high potential side connection terminal of the conductive component; and a fourth conductive layer that connects the low potential side connection terminal of the conductive component and the high potential side connection terminal of the second semiconductor element.

According to this embodiment, the first semiconductor element and the second semiconductor element generate currents in opposite directions in the same layer (on the same plane), so that the effect of cancellation of magnetic fluxes can be further improved, and the switching noise can be reduced more effectively.

In yet another embodiment of the present disclosure, each of the first conductive layer and the second conductive layer may include: a plane portion in which a power supply terminal is provided; and an arm portion that extends from the plane portion and that includes a connection terminal connected to the first semiconductor element or the second semiconductor element.

According to this embodiment, a plane portion in which a power supply terminal is provided and an arm portion connected to a semiconductor element can be made independent, so that flexibility in design of each plane portion or arm portion can be improved.

In still yet another embodiment of the present disclosure, the component-embedded circuit board may include a third semiconductor element, a fourth semiconductor element connected to the third semiconductor element, a fifth semiconductor element, and a sixth semiconductor element connected to the fifth semiconductor element. The arm portion may include: a first arm portion that extends from the plane portion and that includes a connection terminal connected to the first semiconductor element or the second semiconductor element; a second arm portion that extends from the plane portion and that includes a connection terminal connected to the third semiconductor element or the fourth semiconductor element; and a third arm portion that extends from the plane portion and that includes a connection terminal connected to the fifth semiconductor element or the sixth semiconductor element.

According to this embodiment, three half bridges can be provided together, so that a three-phase inverter with less switching noise can be implemented.

### BRIEF DESCRIPTION OF THE DRAWINGS

Embodiments will now be described, by way of example only, with reference to the accompanying drawings which are meant to be exemplary, not limiting, and wherein like elements are numbered alike in several figures, in which:
FIG. 1 is a sectional view of a component-embedded circuit board according to a first embodiment, viewed in a longitudinal direction from a side;
FIG. 2 shows sectional views of the component-embedded circuit board according to the first embodiment, viewed from the top and viewed in a lateral direction from a side;
FIG. 3 is a schematic side view of a first semiconductor element;
FIG. 4 is a sectional view of a component-embedded circuit board according to a comparative example, viewed in a longitudinal direction from a side;
FIG. 5 shows sectional views of the component-embedded circuit board according to the comparative example, viewed from the top and viewed in a lateral direction from a side;
FIG. 6 is a sectional view of a component-embedded circuit board according to a second embodiment, viewed in a longitudinal direction from a side;
FIG. 7 is a sectional view of a component-embedded circuit board according to a modification, viewed in a longitudinal direction from a side;
FIG. 8 is a sectional view of a component-embedded circuit board according to a modification, viewed in a longitudinal direction from a side;
FIG. 9 is a top view of a component-embedded circuit board according to a third embodiment;
FIG. 10 is a top view of a component-embedded circuit board according to a fourth embodiment; and
FIG. 11 is a top view of a component-embedded circuit board according to a modification.

### DETAILED DESCRIPTION OF THE INVENTION

The invention will now be described by reference to the preferred embodiments. This does not intend to limit the scope of the present invention, but to exemplify the invention.

In the following, the present disclosure will be described based on preferred embodiments with reference to the drawings. The embodiments are intended to be illustrative only and not to limit the invention. It should be understood that not all of the features or combinations thereof described in the embodiments are necessarily essential to the invention. Like reference characters denote like or corresponding constituting elements, members, and processes in each drawing, and repetitive description will be omitted as appropriate. The scale or shape of each component shown in each drawing is defined for the sake of convenience to facilitate the explanation and is not to be regarded as limitative unless otherwise specified. Also, when the terms "first", "second", and the like are used in the present specification or claims, such terms do not imply any order or degree of importance and are used to merely distinguish one configuration from another, unless otherwise specified. Further, in each drawing, part of a member less important in describing embodiments may be omitted.

### First Embodiment

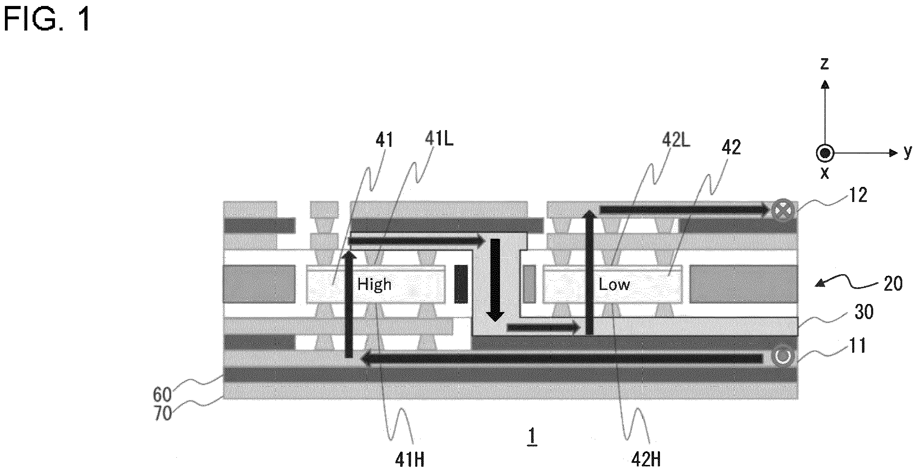

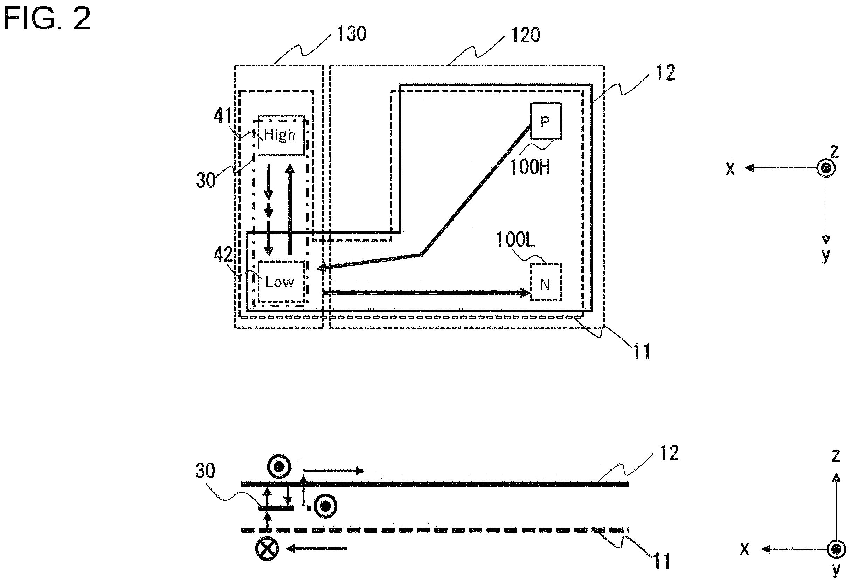

With reference to FIGS. 1 and 2, a configuration of a component-embedded circuit board 1 according to the first embodiment will be described. FIG. 1 is a sectional view of the component-embedded circuit board 1 placed on a horizontal plane and viewed in a longitudinal direction from a side. The upper part of FIG. 2 is a sectional view of the component-embedded circuit board 1 according to the embodiment placed on a horizontal plane and viewed from the top. The lower part of FIG. 2 is a sectional view of the component-embedded circuit board 1 according to the embodiment placed on a horizontal plane and viewed in a lateral direction from a side. Hereinafter in the present specification, when a circuit board is placed on a horizontal plane, a longitudinal direction of the circuit board is defined as the x-axis, a lateral direction thereof is defined as the y-axis, and the vertical upward direction is defined as the z-axis.

The component-embedded circuit board 1 includes a first conductive layer 11, a second conductive layer 12, an insulating layer 20, a first semiconductor element 41, a second semiconductor element 42, and an intermediate conductor 30. In the first conductive layer 11, a high potential side power supply terminal 100H is provided. In the second conductive layer 12, a low potential side power supply terminal 100L is provided. The insulating layer 20 is formed between the first conductive layer 11 and the second conductive layer 12. The first semiconductor element 41 is embedded in the insulating layer 20 and includes a high potential side connection terminal 41H and a low potential side connection terminal 41L exposed from the insulating layer 20. The second semiconductor element 42 is embedded in the insulating layer 20 and includes a high potential side connection terminal 42H and a low potential side connection terminal 42L exposed from the insulating layer 20. The intermediate conductor 30 connects the low potential side connection terminal 41L of the first semiconductor element 41 and the high potential side connection terminal 42H of the second semiconductor element 42. The first semiconductor element 41 and the second semiconductor element 42, which are arranged apart in an in-plane direction of the first conductive layer 11 or the second conductive layer 12, and the intermediate conductor 30 are provided between the first conductive layer 11 and the second conductive layer 12. The high potential side power supply terminal 100H and the high potential side connection terminal 41H of the first semiconductor element 41 exposed from the insulating layer 20 are connected by the first conductive layer 11. The low potential side power supply terminal 100L and the low potential side connection terminal 42L of the second semiconductor element 42 exposed from the insulating layer 20 are connected by the second conductive layer 12. At least one of the first conductive layer 11 or the second conductive layer 12 is configured to have a portion that overlaps the intermediate conductor 30 when viewed from a laminating direction of the first conductive layer 11 and the second conductive layer 12.

In this example, the first semiconductor element 41 and the second semiconductor element 42 function as a switch. At the time, the first semiconductor element 41 is disposed on the high side, and the second semiconductor element 42 is disposed on the low side. In this case, the high potential side power supply terminal 100H has a P potential, and the low potential side power supply terminal 100L has an N potential.

In this example, the first conductive layer 11 and the second conductive layer 12 are formed of copper foil. An insulating layer 32 may include a core layer and a prepreg material.

Although not essential, the component-embedded circuit board 1 may include an insulating sheet 60 and a heat sink 70 on the lower surface of the first conductive layer 11, as shown in FIG. 1. In this case, heat generated by electronic components can be effectively released, which can solve the problem of heat generation associated with the components mounted internally.

As an example, the first semiconductor element 41 and the second semiconductor element 42 are field-effect transistors (FETs). In this case, the high potential side connection terminals 41H and 42H are drain electrode terminals, and the low potential side connection terminals 41L and 42L are source electrode terminals.

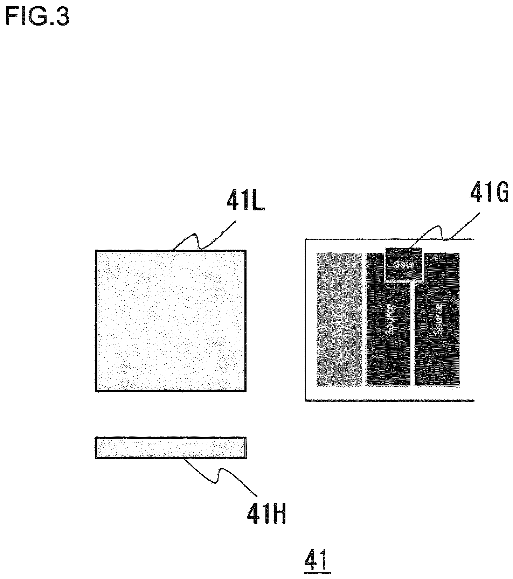

FIG. 3 is a schematic side view of the first semiconductor element 41 (FET). The first semiconductor element 41 includes the high potential side connection terminal 41H (drain electrode terminal) on the lower side, the low potential side connection terminal 41L (source electrode terminal) on the upper side, and a gate electrode terminal 41G formed on part of the source electrode surface. In the following description, the gate electrode terminal may be omitted. The same applies to the second semiconductor element 42.

### Comparative Example

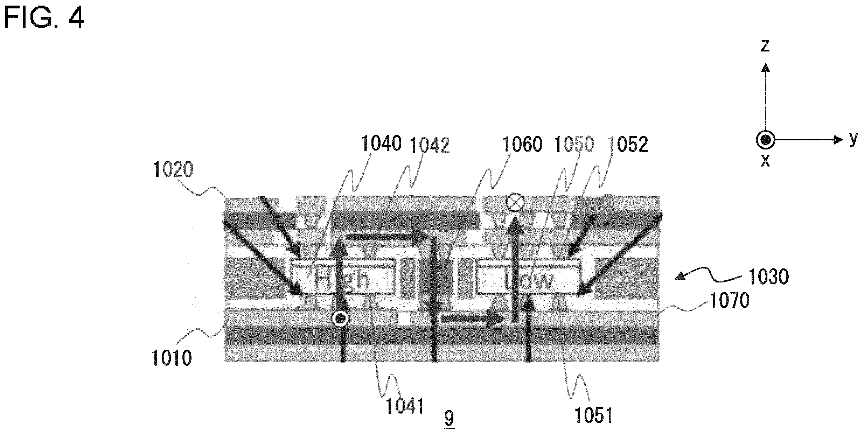

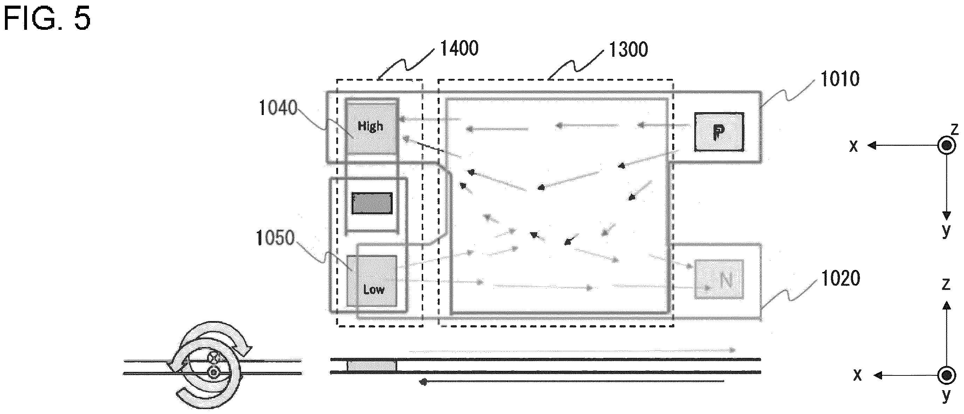

Before the operation of the component-embedded circuit board 1 according to the embodiment is described, the operation of a component-embedded circuit board 9 according to a comparative example, which has been devised in the process leading to the present disclosure, will be described. FIGS. 4 and 5 show the component-embedded circuit board 9 according to the comparative example and correspond respectively to FIGS. 1 and 2.

The component-embedded circuit board 9 includes a first conductive wiring layer 1010, a second conductive wiring layer 1020 laminated on the first conductive wiring layer 1010, an insulating layer 1030 formed between the first conductive wiring layer 1010 and the second conductive wiring layer 1020, and at least one pair of semiconductor elements that are embedded in the insulating layer 1030 and that each include a first electrode terminal and a second electrode terminal. A first electrode terminal 1041 of a first semiconductor element 1040, which is one of the pair of semiconductor elements, is connected to the first conductive wiring layer 1010. A second electrode terminal 1052 of a second semiconductor element 1050, which is the other of the pair of semiconductor elements, is connected to the second conductive wiring layer 1020. The first conductive wiring layer 1010 and the second conductive wiring layer 1020 are formed such that a current flowing through the first conductive wiring layer 1010 and a current flowing through the second conductive wiring layer 1020 are symmetrical and opposite in direction, when viewed from a direction of penetrating the first conductive wiring layer 1010 and the second conductive wiring layer 1020.

In the upper part of FIG. 5, currents flowing through the first conductive wiring layer 1010 and the second conductive wiring layer 1020 when the configuration described above is adopted are schematically illustrated. It can be seen that, by adopting such a configuration, a magnetic flux generated by the current flowing through the first conductive wiring layer 1010 and a magnetic flux generated by the current flowing through the second conductive wiring layer 1020 cancel each other out in a region 1300 surrounded by a dotted line. This can reduce noise caused by switching operation.

However, as shown in FIG. 4, such cancellation of magnetic fluxes cannot be realized in a region 1400 surrounded by a dotted line in the upper part of FIG. 5, where semiconductor elements 1100 and 1200 are mounted. The inductance caused by the magnetic fluxes in this region is relatively large. Therefore, this point is a technical problem of the comparative example.

### First Embodiment (again)

Referring back to FIGS. 1 and 2, the flow of current on the component-embedded circuit board 1 will be described. The current flowing out of the high potential side power supply terminal 100H flows, through the first conductive layer 11, into the first semiconductor element 41 via the high potential side connection terminal 41H. The current flowing into the first semiconductor element 41 flows out via the low potential side connection terminal 41L and flows, through the intermediate conductor 30, into the second semiconductor element 42 via the high potential side connection terminal 42H. The current flowing into the second semiconductor element 42 flows out via the low potential side connection terminal 42L and flows, through the second conductive layer 12, into the low potential side power supply terminal 100L. In FIGS. 1 and 2, this current is schematically shown with solid arrows.

As shown in FIG. 1, in a region 130 where the first semiconductor element 41 and the second semiconductor element 42 are mounted, the current flowing through the first conductive layer 11 from right to left in FIG. 1 is parallel to and opposite in direction to the currents flowing through the intermediate conductor 30 and the second conductive layer 12 from left to right in FIG. 1. Similarly, in the region 130, the current flowing from the first conductive layer 11 through the first semiconductor element 41 to the intermediate conductor 30 and the current flowing from the intermediate conductor 30 through the second semiconductor element 42 to the second conductive layer 12 (the currents flowing from bottom to top in FIG. 1) are parallel to and opposite in direction to the current flowing through the intermediate conductor 30 from top to bottom in FIG. 1. With such currents flowing parallel to and opposite in direction to each other, the magnetic fluxes in the region 130 cancel each other out.

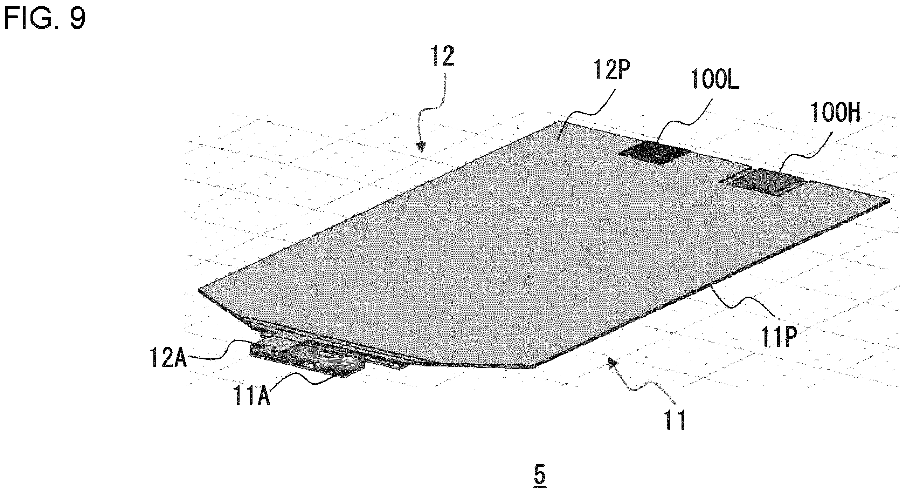

Meanwhile, also in a region 120, the current flowing on the first conductive layer 11 from the high potential side power supply terminal 100H toward the first semiconductor element 41 and the current flowing on the second conductive layer 12 from the second semiconductor element 42 toward the low potential side power supply terminal 100L are almost parallel to and opposite in direction to each other. Although these currents may not appear to be parallel in the schematic FIG. 2, the region 120 is in fact much larger than the region 130, as shown in FIG. 9, so that the current flows are almost parallel also in the region 120. Thus, also within the region 120, the magnetic fluxes cancel each other out.

As described above, according to this embodiment, the magnetic fluxes generated by the currents can cancel each other out over almost the entire area of the component-embedded circuit board 1. Therefore, noise caused by switching operation can be reduced without an additional element, such as a snubber circuit, as conventionally required.

### Second Embodiment

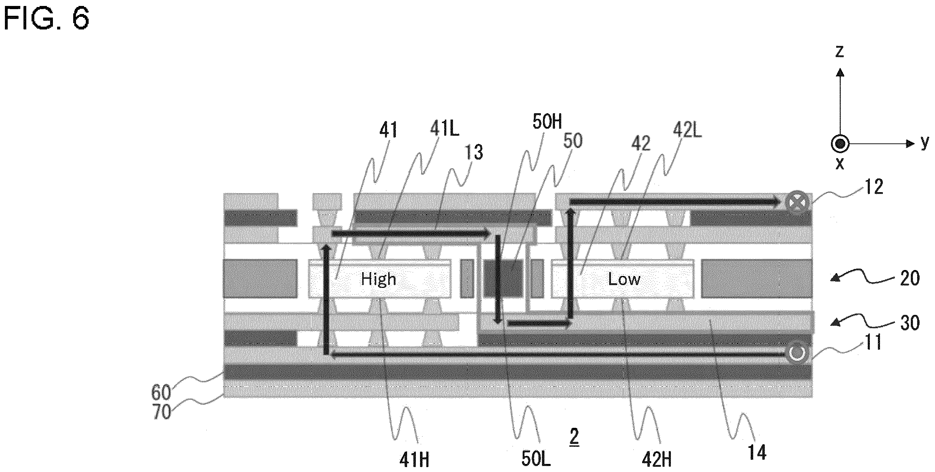

FIG. 6 is a sectional view of a component-embedded circuit board 2 according to the second embodiment placed on a horizontal plane and viewed in a longitudinal direction from a side.

In the component-embedded circuit board 2, the first semiconductor element 41 and the second semiconductor element 42 are embedded in the insulating layer 20 between the first conductive layer 11 and the second conductive layer 12. The intermediate conductor 30 includes a conductive component 50, a third conductive layer, and a fourth conductive layer. The conductive component 50 is embedded in the insulating layer 20 and includes a high potential side connection terminal 50H and a low potential side connection terminal 50L exposed from the insulating layer 20. The third conductive layer 13 connects the low potential side connection terminal 41L of the first semiconductor element 41 and the high potential side connection terminal 50H of the conductive component 50. The fourth conductive layer 14 connects the low potential side connection terminal 50L of the conductive component 50 and the high potential side connection terminal 42H of the second semiconductor element 42.

In this example, the conductive component 50 is formed by a copper block.

As indicated by the solid arrows in FIG. 6, the currents in the region 130 are parallel and opposite in direction also in the component-embedded circuit board 2, which hence achieves effects similar to those of the component-embedded circuit board 1. Furthermore, in the component-embedded circuit board 2, the first semiconductor element 41 and the second semiconductor element 42 generate currents in opposite directions in the same layer (on the same plane), so that the effect of cancellation of magnetic fluxes can be further improved, and the switching noise can be reduced more effectively.

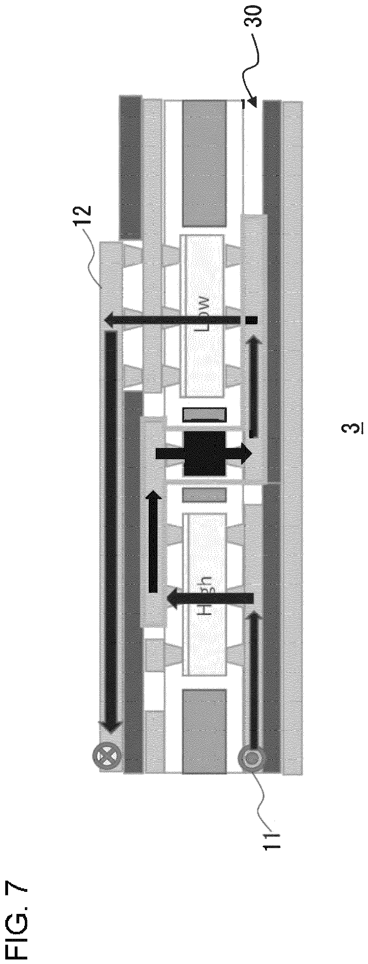

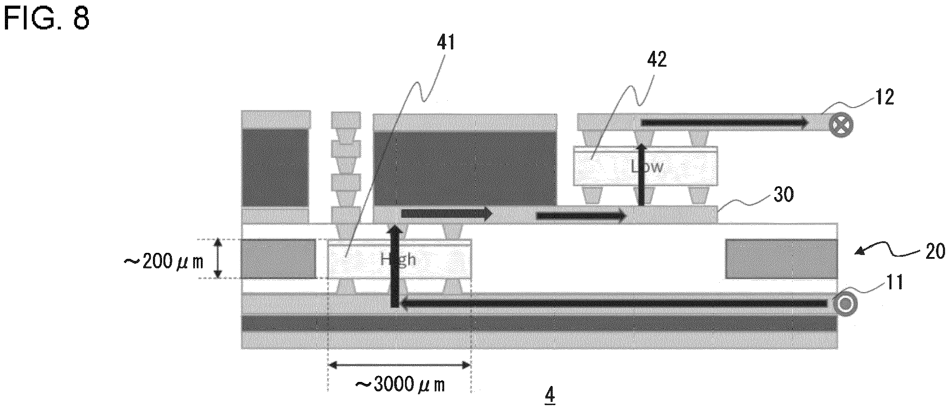

As the component-embedded circuit board according to this embodiment, various other modifications, besides the component-embedded circuit board 2, are conceivable. Such modifications are shown in FIGS. 7 and 8.

FIG. 7 shows a component-embedded circuit board 3 according to a modification of the component-embedded circuit board 2 shown in FIG. 4. In the component-embedded circuit board 2, the first conductive layer 11 is disposed below the second semiconductor element 42 to lie across. In the component-embedded circuit board 3, the first conductive layer 11 does not lie across below the second semiconductor element 42, and instead the second conductive layer 12 lies across above the first semiconductor element 41. Also in this configuration, the currents in the region 130 are parallel and opposite in direction. Therefore, this configuration also achieves the effect of cancellation of magnetic fluxes similar to that of the component-embedded circuit board 2, thereby reducing the switching noise.

FIG. 8 shows a component-embedded circuit board 4 according to a modification of the component-embedded circuit board 1 shown in FIG. 1. In the component-embedded circuit board 4, unlike the component-embedded circuit board 1, the first semiconductor element 41 and the second semiconductor element 42 are not located in the same layer (not on the same plane). More specifically, the second semiconductor element 42 is disposed on the intermediate conductor 30 located on the insulating layer 20 in which the first semiconductor element 41 embedded. In this case, although the currents flowing along a transverse direction in FIG. 8 are parallel and opposite in direction, the currents flowing along a vertical direction in FIG. 8 are parallel but the same in direction. Therefore, in the component-embedded circuit board 4, the magnetic fluxes generated by the currents flowing along a vertical direction in FIG. 8 cannot cancel each other out. However, in general, a semiconductor element used in such an application has a vertical thickness of about 200 um, while the transverse width is about 3000 um. Thus, the vertical thickness is small compared to the transverse width. Accordingly, the performance degradation caused because the magnetic fluxes generated by the currents flowing along a vertical direction cannot cancel each other out is considered to be relatively limitative. Therefore, even with this configuration, the switching noise can be reduced to a certain extent.

### Third Embodiment

FIG. 9 is a perspective view of a component-embedded circuit board 5 according to the third embodiment. The component-embedded circuit board 5 has a configuration similar to that of the component-embedded circuit board 1 shown in FIG. 1 or the component-embedded circuit board 2 shown in FIG. 6. In particular, the first conductive layer 11 of the component-embedded circuit board 5 includes a plane portion 11P and an arm portion 11A. Also, the second conductive layer 12 of the component-embedded circuit board 5 includes a plane portion 12P and an arm portion 12A. In the plane portion 11P of the first conductive layer 11, the high potential side power supply terminal 100H is provided. The arm portion 11A of the first conductive layer 11 extends from the plane portion 11P and includes a connection terminal connected to the first semiconductor element 41. In the plane portion 12P of the second conductive layer 12, the low potential side power supply terminal 100L is provided. The arm portion 12A of the second conductive layer 12 extends from the plane portion 12P and includes a connection terminal connected to the second semiconductor element 42.

According to this embodiment, a plane portion in which a power supply terminal is provided and an arm portion connected to a semiconductor element can be made independent. Therefore, while achieving effects similar to those of the aforementioned embodiments, flexibility in design of each of the plane portions and arm portions can be improved.

### Fourth Embodiment

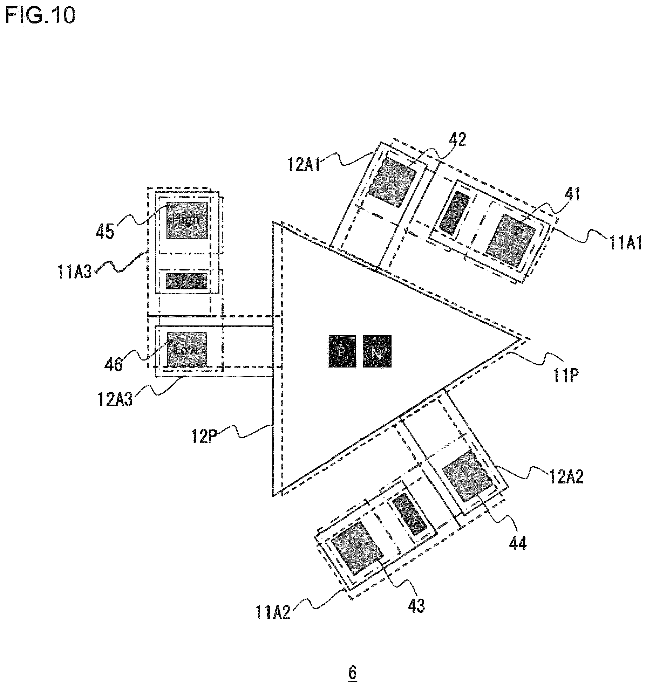

FIG. 10 is a sectional view of a component-embedded circuit board 6 according to the fourth embodiment placed on a horizontal plane and viewed from the top. The component-embedded circuit board 6 includes three sets of the plane portion and the arm portion in the component-embedded circuit board 5 shown in FIG. 9. In specific, the component-embedded circuit board 6 includes, in addition to the first semiconductor element 41 and the second semiconductor element 42, a third semiconductor element 43, a fourth semiconductor element 44 connected to the third semiconductor element 43, a fifth semiconductor element 45, and a sixth semiconductor element 46 connected to the fifth semiconductor element 45. The arm portion 11A of the first conductive layer 11 includes a first arm portion 11A1, a second arm portion 11A2, and a third arm portion 11A3. The arm portion 12A of the second conductive layer 12 includes a first arm portion 12A1, a second arm portion 12A2, and a third arm portion 12A3. The first arm portion 11A1 of the first conductive layer 11 extends from the plane portion 11P and includes a connection terminal connected to the first semiconductor element 41. The first arm portion 12A1 of the second conductive layer 12 extends from the plane portion 12P and includes a connection terminal connected to the second semiconductor element 42. The second arm portion 11A2 of the first conductive layer 11 extends from the plane portion 11P and includes a connection terminal connected to the third semiconductor element 43. The second arm portion 12A2 of the second conductive layer 12 extends from the plane portion 12P and includes a connection terminal connected to the fourth semiconductor element 44. The third arm portion 11A3 of the first conductive layer 11 extends from the plane portion 11P and includes a connection terminal connected to the fifth semiconductor element 45. The third arm portion 12A3 of the second conductive layer 12 extends from the plane portion 12P and includes a connection terminal connected to the sixth semiconductor element 46.

According to this embodiment, three half bridges can be provided together, so that a three-phase inverter with less switching noise can be implemented.

In FIG. 10, each of the plane portion 11P of the first conductive layer and the plane portion 12P of the second conductive layer has an equilateral triangle shape. However, the shape is not limited thereto, and each of the plane portion 11P of the first conductive layer and the plane portion 12P of the second conductive layer may be of any suitable shape.

### Verification

The disclosers conducted simulations to verify the effect of the present disclosure. For the simulations, the electromagnetic field analysis software "Q3D" was used. The loop inductance was calculated for the component-embedded circuit board 5 with the shape shown in FIG. 9 and a component-embedded circuit board with the same shape according to the comparative example, and both the inductances were compared. As a result, the calculated loop inductance was 5.898 nH for the component-embedded circuit board 5 of the embodiment and 9.549 nH for the component-embedded circuit board of the comparative example. Thus, it was found that the technology of the present disclosure can reduce the loop inductance to about 60%, compared to the conventional case.

The present disclosure has been described based on embodiments. The embodiments are intended to be illustrative only, and it will be obvious to those skilled in the art that various modifications and changes could be developed within the scope of claims of the present disclosure and that such modifications and changes also fall within the scope of claims of the present disclosure. Therefore, the description in the present specification and the drawings should be regarded as exemplary rather than limitative.

The semiconductor elements in the embodiments are FETs. However, the semiconductor elements are not limited thereto and may be arbitrary switching semiconductors, such as insulated gate bipolar transistors (IGBTs) and metal-oxide semiconductor field-effect transistors (MOSFETs). The semiconductor material may also be any suitable material, such as Si, SiC, GaN, and Ga₂O₃. This modification allows greater flexibility in configuration.

The material of the board, such as FR4 and CEM3, and the material of the insulating layer, such as prepreg, are not particularly limited and may be any suitable materials. The thickness of a conductor layer is also not particularly limited and may be thicker or thinner than the typical 36 um. The present technology is applicable to both rigid boards and flexible boards. This modification allows greater flexibility in configuration.

The conductive component in the embodiments is formed by a copper block. The copper block may be surface-plated in advance. The conductive component is not limited to a copper block and may be a stack of interlayer VIAs. Also, the material of the conductive component is not limited to copper and may be an arbitrary solderable conductive material. This modification allows greater flexibility in configuration.

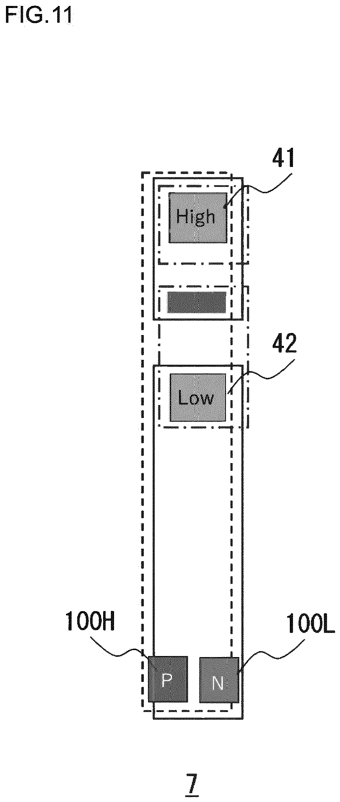

In the examples shown in FIGS. 2 and 10, the arrangement direction of the high potential side power supply terminal 100H and the low potential side power supply terminal 100L is parallel to the arrangement direction of the first semiconductor element 41 and the second semiconductor element 42. However, the arrangement is not limited thereto, and, as in a component-embedded circuit board 7 shown in FIG. 11, the arrangement direction of the high potential side power supply terminal 100H and the low potential side power supply terminal 100L may be perpendicular to the arrangement direction of the first semiconductor element 41 and the second semiconductor element 42.

Optional combinations of the aforementioned embodiments and modifications may also be practiced as additional embodiments of the present disclosure. Such an additional embodiment made by combination has the effect of each of the combined embodiments and modifications.

Embodiments and modifications have been described. In understanding the technical ideas abstracted from the embodiments and modifications, the technical ideas should not be interpreted as limited to the contents of the embodiments and modifications. Each of the aforementioned embodiments and modifications merely describes a specific example, and various design modifications, including changes, addition, and deletion of constituting elements, may be made thereto. In each embodiment, matters to which design modifications may be made are emphasized with the expression of "embodiment". However, design modifications may also be made to matters without such expression.

## Claims

1. A component-embedded circuit board (1), comprising:
a first conductive layer (11) in which a high potential side power supply terminal (100H) is provided;
a second conductive layer (12) in which a low potential side power supply terminal (100L) is provided;
an insulating layer (20) formed between the first conductive layer (11) and the second conductive layer (12);
a first semiconductor element (41) and a second semiconductor element (42) that are embedded in the insulating layer (20) and that each comprise a high potential side connection terminal (41H, 42H) and a low potential side connection terminal (41L, 42L) exposed from the insulating layer (20); and
an intermediate conductor (30) that connects the low potential side connection terminal (41L) of the first semiconductor element (41) and the high potential side connection terminal (42H) of the second semiconductor element (42),
wherein the first semiconductor element (41) and the second semiconductor element (42), which are arranged apart in an in-plane direction of the insulating layer (20), and the intermediate conductor (20) are provided between the first conductive layer (11) and the second conductive layer (12),
wherein the high potential side power supply terminal (100H) and the high potential side connection terminal (41H) of the first semiconductor element (41) exposed from the insulating layer (20) are connected by the first conductive layer (11),
wherein the low potential side power supply terminal (100L) and the low potential side connection terminal (42L) of the second semiconductor element (42) exposed from the insulating layer (20) are connected by the second conductive layer (12), and
wherein at least one of the first conductive layer (11) or the second conductive layer (12) is configured to have a portion that overlaps the intermediate conductor (30) when viewed from a laminating direction of the first conductive layer (11) and the second conductive layer (12).

2. The component-embedded circuit board (2) according to claim 1,
wherein the first semiconductor element (41) and the second semiconductor element (42) are embedded in the insulating layer (20) between the first conductive layer (41) and the second conductive layer (42), and
wherein the intermediate conductor (30) comprises:
a conductive component (50) that is embedded in the insulating layer (20) and that comprises a high potential side connection terminal (50H) and a low potential side connection terminal (50L) exposed from the insulating layer (20) ;
a third conductive layer (13) that connects the low potential side connection terminal (41L) of the first semiconductor element (41) and the high potential side connection terminal (50H) of the conductive component (50); and
a fourth conductive layer (14) that connects the low potential side connection terminal (50L) of the conductive component (50) and the high potential side connection terminal (42H) of the second semiconductor element (42) .

3. The component-embedded circuit board (5) according to claim 1, wherein each of the first conductive layer (11) and the second conductive layer (12) comprises:
a plane portion (12P) in which the power supply terminal is provided; and
an arm portion (11A, 11B) that extends from the plane portion (12P) and that comprises a connection terminal connected to the first semiconductor element (41) or the second semiconductor element (42).

4. The component-embedded circuit board (6) according to claim 3, further comprising a third semiconductor element (43), a fourth semiconductor element (44) connected to the third semiconductor element (43), a fifth semiconductor element (45), and a sixth semiconductor element (46) connected to the fifth semiconductor element (45),
wherein the arm portion (11A, 11B) comprises:
a first arm portion (11A1, 12A1) that extends from the plane portion (12P) and that comprises a connection terminal connected to the first semiconductor element (41) or the second semiconductor element (42);
a second arm portion (11A2, 12A2) that extends from the plane portion (12P) and that comprises a connection terminal connected to the third semiconductor element (43) or the fourth semiconductor element (44); and
a third arm portion (11A3, 12A3) that extends from the plane portion (12P) and that comprises a connection terminal connected to the fifth semiconductor element (45) or the sixth semiconductor element (46).
